# EUROPEAN PATENT APPLICATION

(11) **EP 1 840 657 A1**
(43) Date of publication of application: **03.10.2007**
(21) Application number: 06006362.5
(22) Date of filing: 28.03.2006
(51) Int. Cl.: G03F 7/20

(54) **Support structure for temporarily supporting a substrate**

(71) Applicant: Carl Zeiss SMT AG, 73447 Oberkochen (DE)
(72) Inventor: Kwan, Yim-Bun Patrick, 73431 Aalen (DE); Holderer, Hubert, 73447 Oberkochen (DE); Deyhle, Johannes, 89551 Königsbronn (DE); Ekstein, Claudia, 73479 Ellwangen (DE)
(74) Representative: Cohausz & Florack

(57) **Abstract**

There is provided a support structure for temporarily supporting a substrate in a support direction during treatment of the substrate comprising a base structure and at least one layer connected to the base structure. The at least one layer defines at least one protrusion of the support structure, the at least one protrusion being adapted to contact the substrate when the substrate is supported by the support structure.

## Description

### BACKGROUND OF THE INVENTION

The invention relates to support structures for temporarily supporting a substrate during treatment of the substrate and, in particular, to support structures used in optical systems performing an optical exposure process on a substrate. It also relates to optical exposure apparatuses comprising such a support structure. Furthermore, it relates to methods of manufacturing such support structures. The invention may be used in the context of photolithography processes for fabricating microelectronic devices, in particular semiconductor devices, or in the context of fabricating devices, such as masks or reticles, used during such photolithography processes.

Due to the ongoing miniaturization of semiconductor devices there is a permanent need for enhanced resolution and accuracy of the systems used for fabricating those semiconductor devices. This need for enhanced resolution and accuracy obviously not only pushes the need for an increased performance of the optical system used in the exposure process it also pushes the need for an increased performance of the auxiliary systems participating in the exposure process, such as the support structure supporting the semiconductor device, e.g. a wafer, to be manufactured. Furthermore, to reliably obtain high-quality semiconductor devices it is not only necessary to provide a system having a high nominal performance. It is also necessary to maintain such a high performance throughout the entire exposure process and over the lifetime of the system.

In a conventional microlithography apparatus, such as a so called wafer scanner, a so called wafer table forms the support structure for the wafer during the exposure process. Typically, the wafer table is made of Zerodur® or similar low thermal expansion materials because of their near to zero coefficient of thermal expansion (CTE), so as to provide a thermally insensitive reference for the wafer during the exposure process keeping non-uniform stresses and distortions introduced into the wafer as low as possible. The contact surface between the wafer and the wafer table typically is coated with a thin layer (typically a few microns) of an electrically conductive material. This is done to avoid unwanted electrostatic adhesion of the wafer to the wafer table which otherwise would reduce system performance due to problems when removing the exposed from the wafer table. An example of such coating is titanium nitride (TIN).

The wafer table only contacts the wafer with about 2% of its total surface area, via a plurality of protrusions formed on the wafer table. These protrusions, often called pimples, contact the wafer on a sub-millimeter diameter and are uniformly distributed over the entire support zone of wafer table surface. During exposure of the wafer, debris such as photo resist is transported to the support zone requiring abrasive cleaning of the support zone of the wafer table at regular intervals.

One problem arising with such a wafer table design is the wear of the wafer table in the area of these pimples. With a relatively rigid TiN coating on top of a relatively soft Zerodur® pimple, the high contact pressure between the wafer and the pimple as well as the high shear stress on the pimple during abrasive cleaning often causes break-off of the coating or even fracture of the Zerodur pimples, thus shortening the lifetime of the wafer table to an unacceptable degree.

Alternative solutions have been investigated of using a rigid, abrasion resistant material such as silicon carbide (SiC) as the wafer table material. While this approach may offer many mechanical advantages, the coefficient of thermal expansion of SiC ranges up to 10 to 40 times the coefficient of thermal expansion of the wafer chuck (typically Zerodur® or the like), thus creating extremely tight thermal control requirements in order to avoid differential expansion between the wafer table and the wafer chuck.

### SUMMARY OF THE INVENTION

It is thus an object of the invention to, at least to some extent, overcome the above disadvantages and to provide good and long-term stable performance of a support structure that may be used for temporarily supporting a substrate, in particular of a support structure for a system used in an exposure process.

It is a further object of the invention to easily and reliably increase the lifetime of a support structure that may be used for temporarily supporting a substrate, in particular of a support structure for a system used in an exposure process.

These objects are achieved according to the invention which is based on the teaching that good and long term stable performance of such a support structure may be achieved by a reduction of the local stresses occurring at the interface between the rather rigid abrasion resistant surface material and the rather soft low thermal expansion base material of the support structure. This reduction of the local stresses is achieved according to the invention by providing the protrusions or pimples contacting the substrate mainly via at least one layer formed on the base structure of the support structure.

Other than with the known support structures, there is more space available between the location of the introduction of the stresses into the respective protrusion and the interface between the contact surface forming material and the low thermal expansion base material of the support structure. Thus, stresses may be relieved on their way to this interface leading to lower stress levels and, thus, lower failure rates at this interface increasing lifetime of the support structure.

Thus, according to a first aspect of the invention there is provided a support structure for temporarily supporting a substrate in a support direction during treatment of the substrate comprising a base structure and at least one layer connected to the base structure. The at least one layer defines at least one protrusion of the support structure, the at least one protrusion being adapted to contact the substrate when the substrate is supported by the support structure.

According to a second aspect of the invention there is provided an optical exposure apparatus for transferring an image of a pattern formed on a mask onto a substrate comprising an illumination system adapted to provide light of a light path, a mask unit located within the light path and adapted to receive the mask, a substrate unit located at an end of the light path and adapted to receive the substrate and an optical projection system located within the light path between the mask location and the substrate location and adapted to transfer an image of the pattern onto the substrate. The substrate unit comprises a support structure according to the first aspect of the invention, the support structure being adapted to support the substrate.

According to a third aspect of the invention there is provided a method of manufacturing a support structure for temporarily supporting a substrate in a support direction during treatment of the substrate comprising, in a first step, providing a base structure and, in a second step, providing at least one layer connected to the base structure. The at least one layer has at least one layer section defining at least one protrusion of the support structure, the at least one protrusion being adapted to contact the substrate when the substrate is supported by the support structure.

Preferably, the above aspects of the invention are used in the context of microlithography applications. However, it will be appreciated that the invention may also be used in any other type of optical exposure process or any other type of supporting a substrate during treatment of this substrate.

Further embodiments of the invention will become apparent from the dependent claims and the following description of preferred embodiments which refers to the appended figures. All combinations of the features disclosed, whether explicitly recited in the claims or not, are within the scope of the invention.

### BRIEF DESCRIPTION OF THE DRAWINGS

- Figure 1: is a schematic representation of a preferred embodiment of an optical exposure apparatus according to the invention comprising a preferred embodiment of a support structure according to the invention;
- Figure 2: is a schematic sectional view of a part of the support structure of Figure 1;
- Figure 3: is a block diagram of a preferred embodiment of a method of manufacturing a support structure according to the invention;
- Figure 4: is a schematic sectional view of a first manufacturing state of a further preferred embodiment of a support structure according to the invention that may be used in the optical exposure apparatus of Figure 1;
- Figure 5: is a schematic sectional view of the part of Figure 4 in a second manufacturing state;
- Figure 6: is a schematic sectional view of the part of Figure 4 in a third manufacturing state;
- Figure 7: is a schematic sectional view of a further preferred embodiment of a support structure according to the invention that may be used in the optical exposure apparatus of Figure 1;
- Figure 8: is a block diagram of a further preferred embodiment of a method of manufacturing the support structure according to Figure 7.

### DETAILED DESCRIPTION OF THE INVENTION

### First embodiment

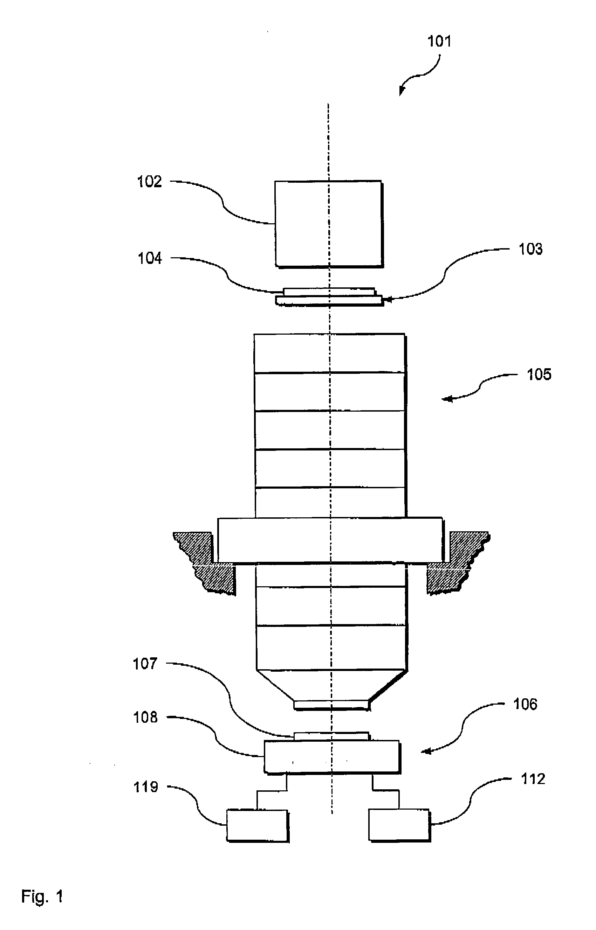

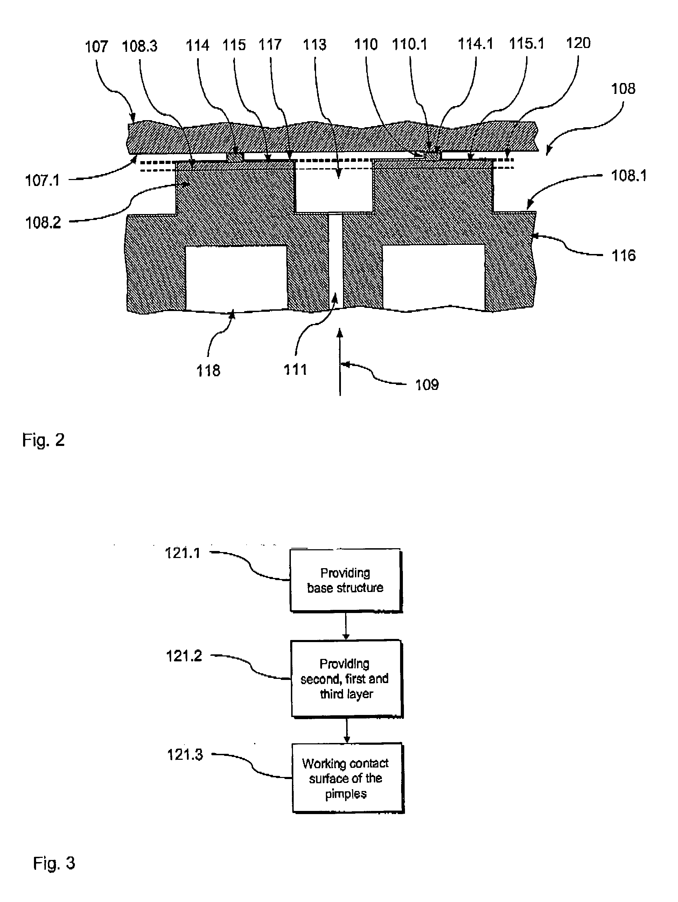

In the following, a first preferred embodiment of an optical exposure apparatus 101 according to the invention comprising an illumination system 102, a mask unit 103 holding a mask 104, an optical projection system 105 and a substrate unit 106 holding a substrate107 will be described with reference to Figures 1 and 2.

The optical exposure apparatus is a microlithography apparatus 101 that is adapted to transfer an image of a pattern formed on the mask 104 onto the substrate 107. To this end, the illumination system 102 illuminates the mask 104 with exposure light. The optical projection system 145 projects the image of the pattern formed on the mask 104 onto the substrate 107, e.g. a wafer or the like.

To this end, the illumination system 102 comprises a light source and a plurality of optical elements, such as lenses, mirrors, gratings or the like, cooperating to define the beam of exposure light by which the mask 104 is illuminated. The optical projection system 104 also comprises a plurality of optical elements, such as lenses, mirrors, gratings or the like, cooperate to transfer an image of the pattern formed on the mask 104 onto the substrate 107.

During the exposure process, i.e. during a certain treatment of the wafer, the wafer 107 is temporarily supported in a support direction 109 by a first preferred embodiment of a support structure according to the invention in the form of a wafer table 108. The wafer table 108 forms part of the substrate unit 106. Depending on the working principle of the of the microlithography apparatus 101 (wafer stepper, wafer scanner or step-and-scan apparatus) the wafer 107 is moved at certain points in time relative to the optical projection system 105. Once the entire wafer has been exposed, the wafer 107 is removed from the wafer table 108.

When supported on the wafer table 108, the lower surface 107.1 of the wafer 107 abuts against the wafer table 108. As can be seen in greater detail from Figure 2 - showing a schematic sectional view of a part of the wafer table 108 of Figure 1 - the wafer table provides a plurality of protrusions in the form of so called pimples 110 that protrude in the support direction 109. The pimples 110 are evenly distributed over the entire support area 108.1 of the wafer table 108 that is provided for supporting such wafers or similar substrates.

To fixedly hold the wafer 107 when moving the wafer table 108 venting channels 111 are provided within the wafer table 108. These venting channels 111 are open towards a space 113 formed between the wafer table 108 and the lower surface 107.1 of the wafer 107. The venting channels 111 are connected to a venting device 112 that may generate a low pressure by drawing the gaseous atmosphere from the space 113. This suction effect generated by the venting device 112 presses the wafer 107 onto the pimples 110. When the wafer 107 is to be removed from the wafer table 108, the venting device 112 stops generating this suction effect. In particular, the venting device 112 may even provide a gaseous medium to the space 113 thus facilitating removal of the wafer 107 from the wafer table 108.

The pimples 110, at the contact surface 110.1 with the wafer 107, have a small diameter of less than 1 mm such that the wafer 107 is effectively contacted only via about 2% of the surface area of its lower surface 107.1. Due to this small contact surface between the wafer 107 and the respective pimple 110, considerable stresses are introduced into the pimple 110.

Furthermore, during the exposure process debris, such as photo-resist from the back side of the wafer 107, may get stuck on the surface of the support area 108.1 of the wafer table 108. Thus, from time to time the support area 108.1 of the wafer table 108 has to be cleaned to maintain a properly defined interface between the respective wafer 107 and the wafer table 108. Typically this cleaning is done using an abrasive cleaning process that imposes considerable shear loads to the surface of the wafer table 108. in particular, iocaiiy concentrated shear loads are imposed to the pimples 110.

To account for these extraordinary boundary conditions during operation and cleaning, in particular these extraordinary local load conditions at the pimples 110, according to one aspect of the invention, the pimples 110 are defined by a first layer 114 of a wear resistant first layer material that is connected via a second layer 115 of a wear resistant second layer material to a base structure in the form of base body 116 of the wafer table 108. A third layer 117 of a wear resistant third layer material is coating the entire support area surface 108.1 of the wafer table 108.

The base body 116 is made of a low thermal expansion material such as Cordierite having a coefficient of thermal expansion of less than 0.5·10⁻⁶ K⁻¹. Thus, the material of the base body 116 in itself already provides a highly thermally stable reference for the wafer 107. To further enhance thermal stability, temperature control channels 118 are provided within the base body 116. These temperature control channels 118 are connected to a temperature control device 119 providing a temperature control medium of suitable temperature to the temperature control channels 118 in order to maintain the temperature of the wafer table 108 within predetermined limits.

It will be further appreciated that, with other embodiments of the invention, other low thermal expansion materials, preferably having a coefficient of thermal expansion of less than 0.5·10⁻⁶ K⁻¹, may be used for the base body as well. Examples of such low thermal expansion materials are quartz, Zerodur®, ULE® glass, CLEARCERAM® etc.

Platform elements 108.2 protruding in the support direction 109 are provided within the base body 116. These platform elements 108.2 each provide a platform 108.3 facing in the support direction 109. The platform elements 108.2 are formed monolithically with the base body 116 by any suitable process. For example the base body 116 may be molded to form these platform elements 108.2. With other variants of the invention, the platform elements 108.2 may be formed from a solid block or a roughly pre-shaped body by any suitable material removing process, e.g. a machining process, an etching process, an erosion process or arbitrary combinations thereof. For example, the platform elements 108.2 may be formed in a masking and etching process, in a blasting process using an abrasive material, in an high energy beam erosion process etc.

The platform elements 108.2 may be substantially uniformly distributed over the support area 108.1. They may be of any suitable shape, e.g. of cylindrical, prismatic or any other shape. Furthermore they may be of a few millimeters in diameter (in a direction transverse to the support direction 109) and of a few tenths of millimeters in height (in the support direction 109). However, it will be appreciated that any other suitable and desired dimensions may be chosen, in particular depending on the substrate to be supported and the load conditions associated therewith,

To account for the load conditions outlined above, in particular, for the load conditions during the regular abrasive cleaning process, the first layer material, the second layer material and the third layer material are all composed of a relatively rigid and wear resistant, electrically conductive titanium nitride (TiN).

A first advantageous aspect thereof is that the use of the wear resistant, in particular abrasion resistant material has the advantage that the abrasive cleaning does not excessively affect the surface of the wafer table 108. A second advantageous aspect is that the electrically conductive material covering the surface of the support area 108.1 of the wafer table 108 avoids static charging of the contact partners avoiding problems associated therewith upon removal of the wafer 107 from the wafer table 108.

A third advantageous aspect results from the arrangement of the first layer 114 and the second layer 115 on the base body. As can be seen from Figure 2, the second layer 115 is discontinuous layer comprising a plurality of second layer sections 115.1 each fully covering the surface of the platform 108.3 of one platform element 108.2. Thus a large area interface is formed between the comparatively rigid second layer 115 and the comparatively soft base body 116. The first layer 194 is also a discontinuous layer comprising a plurality of first layer sections 114.4 each defining one pimple 110 on top of a platform element 108.2.

However, it will be appreciated that, with other embodiments of the invention, the second layer may only extend over a fraction of the respective platform. Furthermore, a different number of pimples per platform may be provided. Furthermore, it is also possible that different platforms of the same wafer table carry different numbers of pimples.

In a direction transverse to the support direction 109, the respective second layer section 115.1 has a considerably larger dimension than the associated first layer section 114.1. Preferably, the respective second layer section 115.1 has about twice the diameter of the associated first layer section 114.1. Furthermore, preferably, the height of the second layer section 115.1, i.e. the dimension in the support direction 109, is at least ten times the height the associated first layer section 114.1. Thus, the respective second layer section 115.1 forms a stress distribution layer between the respective small diameter first layer section 114.1 (defining the respective pimple 110) and the base body 116. The locally concentrated stresses introduced into the pimple 110 (during supporting the wafer 107 and during abrasive cleaning) may be relieved in the stress distribution layer formed by the respective second layer section 115.1 before they reach the critical interface between the comparatively rigid second layer 115 and the comparatively soft base body 116. Thus the likelihood of a component failure at this interface is greatly reduced.

In the embodiment shown the second layer 115 may have a thickness; i.e. a dimension in the support direction 109, of 0.1 mm or even more while the first layer has a thickness of clearly less than 0.1 mm, e.g. 10 to 50 µm. Since the second layer 115 is not a continuous layer but rather a discontinuous or scattered localized structured layer, if desired, even thicker second layers 115 may be provided without generating an undesired bi-metal effect in combination with the material of the base body 116. However, it will be appreciated that, with other embodiments of the invention, other dimensions may be chosen.

Furthermore, it will be appreciated that, with other embodiments of the invention, the platform elements may be omitted and a continuous second layer may be formed on the pianar surface of the base body as it is indicated in Figure 2 by the dashed contour 120. In this case the thickness of the second layer is clearly below 1mm in order to avoid an unwanted bi-metal effect with the base body. In this case the discontinuous first layer, the first layer sections of which define the pimples, may have a thickness between a few microns and a few tenths of millimeters. Furthermore, in this case, the continuous second layer, eventually together with the discontinuous first layer, may form the electrically conductive surface of the wafer table such that, eventually, the third layer may be omitted.

The third layer 117 typically has a substantially continuous thickness of less than one micron. It may simply serve to provide the electrically conductive connection between the otherwise electrically isolated components (i.e. the respective electrically conductive pair of a first layer section 114.1 and a second layer section 115.1) located on different platforms 108.3.

It will be appreciated that any one of the first layer 114, the second layer 115 and the third layer 117 may be made of any other suitable, preferably wear resistant and/or electrically conductive material. Such suitable materials are for example carbides, nitrides, borides, oxides, silicides. In particular, a silicon carbide (SiC), a tungsten carbide (WC), a titanium nitride (TiN), a diamond-like carbon (DLC), a diamond, a mono-crystalline silicon or a mono-crystalline germanium may be used. Furthermore, arbitrary layer combinations of such materials may be used. However, it will be appreciated that, for the first layer 114 and/or the second layer 115, electrical conductivity is not absolutely necessary if the third layer 117 is electrically conductive.

The first layer 114, the second layer 115 and the third layer 117 may be deposited or otherwise attached to their respective partner by any suitable process providing the arrangement described above. Examples of such processes are sputter processes, physical vapor deposition (PVD) processes, chemical vapor deposition (CVD) processes or the like. Furthermore, it will be appreciated that the geometry described above, in particular the combined geometry of the first and second layer, may also be obtained by removing material from a single layer previously deposited or attached or by depositing or attaching a single layer of locally varying thickness, e.g. using a molding or a masking process. Such a monolithic connection between the first layer and the associated second layer has the advantage that no critical interface zone is formed between them and an optimized flow of stresses from the first layer into the associated second layer may be obtained further reducing the likelihood of a component failure.

In particular, when using a molding or a masking process, one or more layers of locally varying thickness, i.e. layers having an arbitrarily stepped and/or curved cross-section may be obtained. This may for example be used for optimizing the shape of the pimples 110.

It will be appreciated that, if the required planarity tolerances of the contact surfaces 110.1 of the pimples 110 with the wafer 107 are not provided by the layer deposition processes used, the contact surfaces 110.1 may be commonly worked using a suitable process in order to meet these planarity tolerances. Examples of such working processes are polishing, lapping or the like.

If this is the case, preferably, the space 113 between the pimples 110 is filled with a preferably easily removable filling material, such as a lacquer or the like, up to the top of the pimples to avoid deposition of less easily removable substances on the surface of the wafer table 108. The continuous surface obtained with this filling material also provides the possibility to easily perform an interferometric determination of the surface shape.

Figure 3 shows a block diagram of a preferred embodiment of a method of manufacturing the wafer table 108 according to the invention that is used during operation of the optical exposure apparatus 101.

In a first step 121.1, the base body 116 is provided having the shape as described above. To this end, in a first partial step, two pieces of bulk cordierite sinter material are pre-sintered to a certain density degree, e.g. 80% of the final density of the base body 116, to provide an upper half pre-form and a lower half pre-form of the base body 106. in a second partial step, all the features of the base body 116. e.g. the venting channels 111, the cooling channels 118 and the platform elements 108.2 are machined to the respective upper half pre-form and a lower half pre-form of the base body 106. In a third partial step, the upper half pre-form and a lower half pre-form of the base body 106 are connected and then fully sintered together with a thin layer of bonding material in between them. The bonding material is preferably substantially similar to the material of the pre-forms. Such a process allow very good final tolerances to be achieved at the finished base body while retaining full material properties at the bonding interface.

As a first alternative, in a first partial step of the first step 121.1, at least a first component and a second component of the base body 116 are given their final shape and fully sintered. In a second partial step, the fully sintered first component and the fully sintered second component of the base body 116 are bonded together to form the base body 116 with all its features. The bonding process can be any of the usual ceramic bonding processes, including fusion bonding, glass bonding, brazing, or so-called low temperature bonding.

As a second alternative, in the first step 121.1, the base body 116 is manufactured monolithically in one piece using a stereolithography process in combination with laser assisted sintering.

In a second step 121.2, the second layer 115 is deposited onto the platforms 108.3 of the platform elements 108.2 using a physical vapor deposition (PVD) process combined with a masking process. Then, the first layer 114 is deposited onto the second layer 115 to provide the configuration described above. Here as well a PVD process is used in combination with a masking process to provide the discontinuous first layer 114. Finally, the third layer 117 is deposited on the entire surface of the support area 108.1 in a PVD process.

It will be appreciated that, with other embodiments of the invention, other suitable layer deposition processes, such as e.g. chemical vapor deposition (CVD) or sputtering, may be used for any one of the first to third layer. Furthermore, arbitrary combinations of such processes may be used for providing the first to third layer.

In a third step 121.3, if necessary, the contact surfaces 110.1 of the pimples 110 are commonly worked to meet the planarity requirements for providing proper support to the respective wafer 107. Suitable working processes are for example commonly polishing or lapping the contact surfaces 110.1.

To measure the resulting global thickness of the wafer table 108, an ultra-flat reference wafer may be placed on top of the pimples 110 with a slight vacuum applied via the venting channels 111. The top surface of the reference wafer may then be used for indirect measurement using a large area plane interferometer. The unevenness of the reference wafer itself can be calibrated out if the measurement is repeated multiple times with the wafer and the wafer table 108 being rotated relative to each other, e.g. at four times 90°.

### Second embodiment

In the following, a second preferred embodiment of an support structure in the form of a wafer table 208 according to the invention will be described with reference to Figure 1 and 4 to 6. The wafer table 208, in its basic design and functionality, largely corresponds to the wafer table 108 and may replace the wafer table 108 in the exposure apparatus 101 of Figure 1. Thus, it is here mainly referred to the differences. The wafer table 208 may furthermore be manufactured using a method according to the invention similar to the one described in the context of Figure 3.

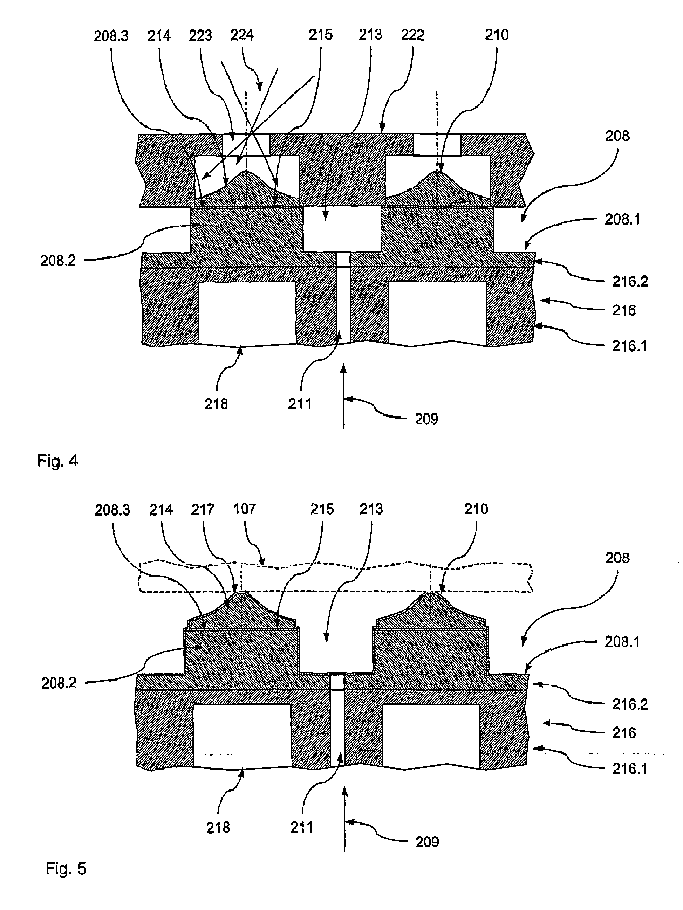

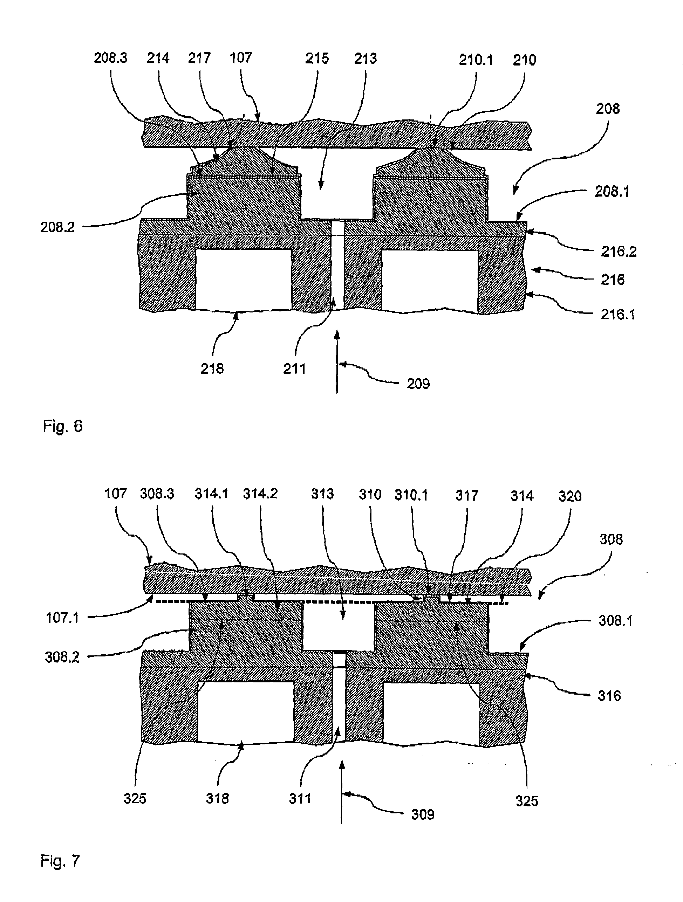

Figure 4 shows a schematic sectional view of a part of the wafer table 208 in a first manufacturing state, while Figures 5 and 6 show a schematic sectional views of the part of the wafer table 208 shown in Figure 4 in a second and third manufacturing state, respectively.;

When supported on the wafer table 208, the lower surface 207.1 of the wafer 207 abuts against the wafer table 208. As can be seen in greater detail from Figure 6 the wafer table 208 provides a plurality of protrusions in the form of so called pimples 210 that protrude in the support direction 209. The pimples 210 are evenly distributed over the entire support area 208.1 of the wafer table 208 that is provided for supporting such wafers or similar substrates.

To fixedly hold the wafer 207 when moving the wafer table 208 venting channels 211 are provided and connected to the venting device 112. These venting channels 211, in their design and operation, are similar to the venting channels 111 of Figure 2 such that it is here only referred to the explanations given above.

The pimples 210, at the contact surface 210.1 with the wafer 207, have a small diameter of less than 1 mm such that the wafer 207 is effectively contacted only via about 2% of the surface area of its lower surface 207.1. Due to this small contact surface between the wafer 207 and the respective pimple 210, considerable stresses are introduced into the pimple 210. Furthermore, abrasive cleaning of the wafer table 208 also imposes considerable shear loads to the surface of the wafer table 208. In particular, locally concentrated shear loads are imposed to the pimples 210.

To account for these extraordinary boundary conditions during operation and cleaning, in particular these extraordinary local load conditions at the pimples 210, according to one aspect of the invention, the pimples 210 are defined by a first layer 214 of a wear resistant first layer material, that is connected via a second layer 215 of a second layer material to a base structure 216 of the wafer table 208. A third layer 217 of a wear resistant third layer material is coating almost the entire surface 208.1 of the wafer table 208.

A first difference to the wafer table 108 lies within the design of the base structure 216, As can be seen from the Figures 4 to 6, although having the same outer shape as the base structure 116, the base structure 216 is made of a base body 216.1 and a plurality of carrier elements 216,2 mounted on top of the base body 216.1. While the base body 216.1 forms the temperature control channels, the carrier elements 216.2 form the platform elements 208.2.

The base body 216.1 again is made of a low thermal expansion material such as Cordierite having a coefficient of thermal expansion of substantially less than 0.5·10⁻⁶ K⁻¹. Thus, the material of the base body 216 in itself already provides a highly thermally stable reference for the wafer 207. To further enhance thermal stability, temperature control channels 218 are provided within the base body 216. These temperature control channels 218 are connected to the temperature control device 119 of Figure 1 maintaining the temperature of the wafer table 208 within predetermined limits. As mentioned above, other low thermal expansion materials, preferably having a coefficient of thermal expansion of less than 0.5·10⁻⁶ K⁻¹, may be used for the base body as well. Examples of such low thermal expansion materials are quartz, Zerodur®, ULE® glass, CLEARCERAM® etc.

The platform elements 208.2 are identical in shape and function to the platform elements 108.2 of Figure 2. They are formed monolithically with the respective carrier element 216.2 by any suitable process. For example the carrier element 216.2 may be molded to form these platform elements 208.2. With other variants of the invention, the platform elements 208.2 may be formed from a solid block or a roughly pre-shaped body by any suitable material removing process, e.g. a machining process, an etching process, an erosion process or arbitrary combinations thereof. For example, the platform elements 208.2 may be formed in a masking and etching process, in a blasting process using an abrasive material, in an high energy beam erosion process etc.

The platform elements 208.2 may be substantially uniformly distributed over the support area 208.1. They may be of any suitable shape, e.g. of cylindrical, prismatic or any other shape. Furthermore they may be of a few millimeters in diameter (in a direction transverse to the support direction 209) and of a few tenths of millimeters in height (in the support direction 209). However, it will be appreciated that any other suitable and desired dimensions may be chosen, in particular depending on the substrate to be supported and the load conditions associated therewith.

To account for the load conditions outlined above, in particular, for the load conditions during the regular abrasive cleaning process, the carrier elements are made of a relatively rigid and wear resistant, electrically conductive titanium nitride (TiN). However, they may also be made of any other suitable, preferably wear resistant and/or electrically conductive material. Such suitable materials are for example carbides, nitrides, borides, oxides, silicides. In particular, a silicon carbide (SiC), a tungsten carbide (WC), a titanium nitride (TiN), a diamond-like carbon (DLC), a diamond, a mono-crystalline silicon or a mono-crystalline germanium may be used. Furthermore, arbitrary combinations of such materials may be used.

A first advantageous aspect thereof is that the use of the wear resistant, in particular abrasion resistant material has the advantage that the abrasive cleaning does not excessively affect the surface of the wafer table 208. A second advantageous aspect is that the electrically conductive material forming the surface of the contact area 208.1 of the wafer table 208 avoids static charging of the contact partners avoiding problems associated therewith upon removal of the wafer 207 from the wafer table 208. If necessary, an electrically conducting connection is provided between the carrier elements 216.2. This may be done by any suitable connection at the interface between two adjacent carrier elements 216.2, Also an electrically conductive coating 217 similar to the third layer 117 of Figure 2 may be provided to the surface of the contact area 208.1 of the wafer table 208 .

A third advantageous aspect results from the large area interface thus formed between the comparatively rigid carrier elements 216.2 and the comparatively soft base body 216.1. Thus, the carrier elements 216.2 form a stress distribution layer between the respective pimple 210 and the base body 216.1. The locally concentrated stresses introduced into the pimple 210 (during supporting the wafer 107 and during abrasive cleaning) may be relieved in the stress distribution layer formed by the respective carrier element 216.2 before they reach the critical interface between the comparatively rigid carrier element 216.2 and the comparatively soft base body 216. Thus the likelihood of a component failure at this interface is greatly reduced.

The carrier elements 216.2 are bonded to the base body 216.1 by any suitable process. Examples for such processes are wringing, soldering, adhesive bonding, fusion bonding, low temperature bonding etc. To avoid an undesired bi-metal effect, the thickness of the carrier elements 216,2, i,e. their dimension in the support direction is about a few tenths of millimeters. They may extend over some square centimeters (cm²) of the surface of the base body 216.1. Their maximum size is defined by the maximum admissible stress and their material parameters.

The pimples 210 are formed on the platform elements 208.2 in a masked sputter coating process. As can be seen from Figure 4 (showing the situation short before the end of the masked sputter coating process), a mask 222 having apertures 223 is placed on the platform elements 208.2. Preferably, this is done after the carrier elements 216.2 have been mounted to the base body 216.1. However, this may also be done prior to mounting the carrier elements 216.2 to the base body 216.1.

The apertures 223 are located such that accelerated sputter material - as indicated in Figure 4 by the arrows 224 - may reach most of the surface area of the respective platform 208.3 formed on the platform elements 208.2 while the remaining surface of the wafer table 208 is shielded by the mask 223. In the support direction, the apertures 223 are located at a distance from the respective platform 208.3 and, in a direction transverse to the support direction, have a first diameter that is smaller than the second diameter of the free surface of the platform 208.3. Thus, during the sputter process a first layer 214 of sputter material is formed on the platform 208.3.

The first layer 214 is a discontinuous layer with a plurality of first layer sections having a Gaussian-curve-like thickness profile. The exact shape of the thickness profile depends, among others, on the ratio of the first and second diameter and the distance of the apertures 223 from the respective platform 208.3. Thus, by properly selecting the first diameter and the distance of the apertures 223 from the respective platform 208.3, the shape of the thickness profile may be varied in a wide range. In any case, in the centrally located region of its maximum thickness, the first layer 214 defines the contact area between the pimple 210 and the wafer 107.

It will be appreciated in this context that a sharp thickness variation in the region of the pimple 210 (approximated to the stepped design shown in Figure 2) is preferred from a thermal point of view. In this case, among others due to the more uniform gap between the wafer and the wafer table, a more uniform heat transfer between the wafer and the wafer table is obtained leading to a more uniform temperature profile in the wafer.

An advantageous aspect of this embodiment results from the thickness profile of the first layer sections 214.1, Despite providing a desirably small contact area between the respective pimple 210 and the wafer 107, the thickness profile of the first layer 214 guarantees a large area interface between the first layer section 214.1 and its underlying platform element structure. Thus, the first layer section 214.1 in itself forms a stress distribution layer between the small diameter contact area between the pimple 210 and the wafer 107 and the large area interface to the platform element of the base structure 216. The locally concentrated stresses introduced into the pimple 210 (during supporting the wafer 207 and during abrasive cleaning) may be relieved in the stress distribution layer formed by the respective first layer section 214.1 before they reach the interface between the respective first layer section 214.1 and underlying platform element of the base structure 216.

This stress distribution layer with the large area interface formed by the respective first layer section 214,1 is particularly advantageous in other embodiments of the invention where the base structure is designed like the base structure 116, i.e. from a relatively soft base body forming the platform elements to which the first layer 214 is connected. Here, the likelihood of a component failure at the interface is greatly reduced.

It will be appreciated that, with other embodiments of the invention, the first layer may only extend over a fraction of the respective platform. Furthermore, a different number of pimples per platform may be provided.

In the embodiment shown the first layer 214 may have a maximum thickness, i.e. a dimension in the support direction 209, of about 0.1 mm or even more. However, it will be appreciated that, with other embodiments of the invention, other dimensions may be chosen.

Furthermore, it will be appreciated that, with other embodiments of the invention, the platform elements may be omitted and a continuous second layer may be formed on the planar surface of the base body as it is indicated in Figure 2 by the dashed contour 220. In this case the thickness of the carrier elements is clearly below 1 mm in order to avoid an unwanted bi-metal effect with the base body. In this case the discontinuous first layer, the first layer sections of which define the pimples, may have a thickness between a few microns and a few tenths of millimeters.

As can be seen from Figures 4 to 6, a second layer 215 has been formed on the respective platform 208.3 in a step prior to forming the first layer 214 in the sputter process. This second layer 215 may be a layer enhancing adhesion between the first layer 214 and the platform 208.3. Suitable materials for the second layer 215 are for example chromium (Cr) and tungsten titanium (WTi). However, it will be appreciated that this second layer may also be omitted.

In a step following the sputter process, the electrically conductive coating 217 mentioned above is deposited as a third layer over the entire support area 208.1 of the wafer table 208. However, as mentioned above, this layer may also be omitted if electrical conductivity and, thus, anti-static behavior of the of the surface of the wafer table 208 is guaranteed by other means. The third layer 217 typically has a substantially continuous thickness of about a few microns. It may simply serve to provide the electrically conductive connection between the otherwise electrically isolated first layer sections 214.1 and second layer sections 215.1, respectively.

It will be appreciated that any one of the first layer 214, the second layer 215 and the third layer 217 may be made of any suitable, preferably wear resistant and/or electrically conductive material. Such suitable materials are for example carbides, nitrides, borides, oxides, silicides. In particular, a silicon carbide (SiC), a tungsten carbide (WC), a titanium nitride (TIN), a diamond-like carbon (DLC), a diamond, a mono-crystalline silicon or a mono-crystalline germanium may be used. Furthermore, arbitrary layer combinations of such materials may be used.

The first layer 214, the second layer 215 and the third layer 217 may be deposited by any suitable process providing the arrangement described above. Examples of such processes are sputter processes, physical vapor deposition (PVD) processes, chemical vapor deposition (CVD) processes or the like. Furthermore, it will be appreciated that the geometry described above, in particular the combined geometry of the first and second layer, may also be obtained by removing material from a single layer previously deposited or by depositing a single layer of locally varying thickness, e.g. using a molding or a masking process.

It will be appreciated that, if the required planarity tolerances of the contact surfaces 210.1 of the pimples 210 with the wafer 207 are not provided by the layer deposition processes used, i.e. not obtained with the geometry shown in Figure 5, the contact surfaces 210.1 may be commonly worked using a suitable process in order to meet these planarity tolerances. This leads to a geometry as it is shown in Figure 6. Examples of such working processes are polishing, lapping or the like.

If this is the case, preferably, the space 213 between the pimples 210 is filled with a preferably easily removable filling material, such as a lacquer or the like, up to the top of the pimples to avoid deposition of less easily removable substances on the surface of the wafer table 208. The continuous surface obtained with this filling material also provides the possibility to easily perform an interferometric determination of the surface shape.

It will be appreciated that the wafer table 208 may be manufactured in a method similar to the one described in the context of Figure 3 but respecting the differences outlined above.

### Third embodiment

In the following, a third preferred embodiment of an support structure in the form of a wafer table 308 according to the invention will be described with reference to Figure 1, 7 and 8. The wafer table 308, in its basic design and functionality, largely corresponds to the wafer table 108 and may replace the wafer table 108 in the exposure apparatus 101 of Figure 1. Thus, it is here mainly referred to the differences.

When supported on the wafer table 308, the lower surface 107.1 of the wafer 107 abuts against the wafer table 308. As can be seen in greater detail from Figure 7 - showing a schematic sectional view of a part of the wafer table 308 - the wafer table provides a plurality of protrusions in the form of so called pimples 310 that protrude in the support direction 309. The pimples 310 are evenly distributed over the entire support area 308.1 of the wafer table 308 that is provided for supporting such wafers or similar substrates.

To fixedly hold the wafer 107 when moving the wafer table 308 venting channels 311 are provided within the wafer table 308. These venting channels 311 are open towards a space 313 formed between the wafer table 308 and the lower surface 107.1 of the wafer 107. The venting channels 311 are connected to the venting device 112 (see Figure 1) that may generate a low pressure by drawing the gaseous atmosphere from the space 313. This suction effect generated by the venting device 112 presses the wafer 107 onto the pimples 310. When the wafer 107 is to be removed from the wafer table 308, the venting device 112 stops generating this suction effect In particular, the venting device 112 may even provide a gaseous medium to the space 313 thus facilitating removal of the wafer 107 from the wafer table 308.

The pimples 310, at the contact surface 310.1 with the wafer 107, have a small diameter of less than 1 mm such that the wafer 107 is effectively contacted only via about 2% of the surface area of its lower surface 107.1. Due to this small contact surface between the wafer 107 and the respective pimple 310, considerable stresses are introduced into the pimple 310.

Furthermore, during the exposure process debris, such as photo-resist from the back side of the wafer 107, may get stuck on the surface of the support area 308.1 of the wafer table 308. Thus, from time to time the support area 308.1 of the wafer table 308 has to be cleaned to maintain a properly defined interface between the respective wafer 107 and the wafer table 308. Typically this cleaning is done using an abrasive cleaning process that imposes considerable shear loads to the surface of the wafer table 308. In particular, locally concentrated shear loads are imposed to the pimples 310.

To account for these extraordinary boundary conditions during operation and cleaning, in particular these extraordinary local load conditions at the pimples 310, according to one aspect of the invention, the pimples 310 are defined by a first layer section 314.1 of a first layer 314 of a wear resistant first layer material that is connected to a base structure in the form of base body 316 of the wafer table 308. A further layer 317 of a further wear resistant layer material is coating the entire support area surface 308.1 of the wafer table 308.

The base body 316 is made of a low thermal expansion material such as Cordierite having a coefficient of thermal expansion of less than 0.5·10⁻⁶ K⁻¹. Thus, the material of the base body 316 in itself already provides a highly thermally stable reference for the wafer 107. To further enhance thermal stability, temperature control channels 318 are provided within the base body 316. These temperature control channels 318 are connected to a temperature control device 319 providing a temperature control medium of suitable temperature to the temperature control channels 318 in order to maintain the temperature of the wafer table 308 within predetermined limits.

It will be further appreciated that, with other embodiments of the invention, other low thermal expansion materials, preferably having a coefficient of thermal expansion of less than 0.5·10⁻⁶ K⁻¹, may be used for the base body as well. Examples of such low thermal expansion materials are quartz, Zerodur®, ULE® glass, CLEARCERAM® etc.

Platform elements 308.2 protruding in the support direction 309 are provided by a second layer section 314.2 within the first layer 314. These platform elements 308.2 each provide a platform 308.3 facing in the support direction 309. Each second layer section 314.2 forming a platform element 308.2, on its platform 308.3, carries one first layer section 314.1 monolithically connected thereto and defining a pimple 310. However, it will be appreciated that, with other embodiments of the invention, a different number of pimples per platform may be provided. Furthermore, it is also possible that different platforms of the same wafer table carry different numbers of pimples.

The platform elements 308.2 are formed monolithically within the first layer 314 by any suitable process. For example the first layer 314 may be molded to form these platform elements 308.2. With other variants of the invention, the platform elements 308.2 may be formed from a solid block or a roughly pre-shaped body by any suitable material removing process, e.g. a machining process, an etching process, an erosion process or arbitrary combinations thereof. For example, the platform elements 308.2 may be formed in a masking and etching process, in a blasting process using an abrasive material, in an high energy beam erosion process etc.

In the embodiment shown, the platform elements 308.2 are formed by a blasting process using an abrasive material, e.g. a sand blasting process, as will be explained in further detail below. The platform elements 308.2 may be substantially uniformly distributed over the support area 308.1, They may be of any suitable shape, e.g. of cylindrical, prismatic or any other shape. Furthermore they may be of a few millimeters in diameter (in a direction transverse to the support direction 309) and of a few tenths of millimeters in height (in the support direction 309). However, it will be appreciated that any other suitable and desired dimensions may be chosen, in particular depending on the substrate to be supported and the load conditions associated therewith.

To account for the load conditions outlined above, in particular, for the load conditions during the regular abrasive cleaning process, the first layer material of the first layer 314 is a relatively rigid and wear resistant, electrically conductive silicon carbide (SiC) while the layer material of the further layer 317 is composed of a relatively rigid and wear resistant, electrically conductive titanium nitride (TiN).

A first advantageous aspect thereof is that the use of the wear resistant, in particular abrasion resistant material has the advantage that the abrasive cleaning does not excessively affect the surface of the wafer table 308. A second advantageous aspect is that the electrically conductive material covering the surface of the support area 308.1 of the wafer table 308 avoids static charging of the contact partners avoiding problems associated therewith upon removal of the wafer 107 from the wafer table 308.

A third advantageous aspect results from the arrangement of the first layer section 314.1 and the second layer section 314.2 on the base body 316. As can be seen from Figure 7, the first layer 314 forms a continuous layer fully covering the upper surface of the base body 316. Thus a large area interface is formed between the comparatively rigid first layer 314 and the comparatively soft base body 316.

in a direction transverse to the support direction 309, the respective second layer section 314.2 has a considerably larger dimension than the associated first layer section 314.1 monolithically connected thereto. Preferably, the respective second layer section 314.2 has about twice the diameter of the associated first layer section 314.1. Furthermore, preferably, the height of the second layer section 314.2, i.e. the dimension in the support direction 309, is at least ten times the height the associated first layer section 314.1. Thus, the respective second layer section 314.2 forms a stress distribution layer between the respective small diameter first layer section 314.1 (defining the respective pimple 310) and the base body 316. The locally concentrated stresses introduced into the pimple 310 (during supporting the wafer 107 and during abrasive cleaning) may be relieved in the stress distribution layer formed by the respective second layer section 314.2 before they reach the critical interface between the second layer section 314.2 of the comparatively rigid first layer 314 and the comparatively soft base body 316. Thus the likelihood of a component failure at this interface is greatly reduced.

Furthermore, the monolithic design of the first layer section 314.1 and the associated second layer section 314.2 has the advantage that no critical interface zone is formed and an optimized flow of stresses from the first layer section 314.1 into the associated second layer section 314.2 may be obtained further reducing the likelihood of a component failure,

In the embodiment shown the second layer section 314.2 may have a thickness, i.e. a dimension in the support direction 309, of 0.1 mm or even more, typically from 50 µm to 200 µm, while the first layer section has a thickness of clearly less than 0.1 mm, typically from 1 to 20 µm. Thanks to the platform elements 308.2 formed by the second layer sections 314.2, if desired, even thicker second layer sections 314.2 may be provided without generating an undesired bi-metal effect in combination with the material of the base body 316. However, it will be appreciated that, with other embodiments of the invention, other dimensions may be chosen.

Furthermore, it will be appreciated that, with other embodiments of the invention, the platform elements may be omitted and a second layer section of uniform thickness may be formed on the planar surface of the base body as it is indicated in Figure 7 by the dashed contour 320. In this case the thickness of the second layer section is clearly below 1 mm in order to avoid an unwanted bi-metal effect with the base body. In this case the discontinuous first layer sections defining the pimples may have a thickness between a few microns and a few tenths of millimeters. Furthermore, in this case, the second layer section together with the first layer sections may form the electrically conductive surface of the wafer table such that, eventually, the further layer 317 may be omitted.

Then, in a sandblasting process, the raw outer shape of the platform elements 308.2 is formed from the first layer 314. It will be appreciated that, in certain embodiments of the invention, where, in the sandblasting process, not only the first layer but also the base body is machined forming the raw outer shape of the platform elements 308.2 from the first layer and the base body and providing a design as it has been described above as an alternative in the context of the first embodiment.

Furthermore, it will be appreciated that, with other embodiments of the invention, the total thickness of the platform elements and the pimples may exceed the thickness of the first layer. In this case, the platform elements are formed in part by the base body and in part by the second layer section of the first layer as it is indicated in Figure 7 by the dashed contours 325. In this case, similar to the configuration of the first embodiment, the first layer is a discontinuous layer with mutually isolated segments 325 of the first layer sitting on the respective parts of the platform elements formed by the base body. In this case, the further layer 317 may serve to provide the electrically conductive connection between these segments 325 of the first layer.

The further layer 317 typically has a substantially continuous thickness of less than one micron. It may simply serve to guarantee the electrically conductive connection between the first layer sections 314.1 and second layer sections 314.2 over the entire surface of the wafer table 308.

It will be appreciated that any one of the first layer 314 and the further layer 317 may be made of any other suitable, preferably wear resistant and/or electrically conductive material. Such suitable materials are for example carbides, nitrides, borides, oxides, silicides. In particular, a silicon carbide (SiC), a tungsten carbide (WC), a titanium nitride (TiN), a diamond-like carbon (DLC), a diamond, a mono-crystalline silicon or a mono-crystalline germanium may be used. Furthermore, arbitrary layer combinations of such materials may be used.

The first layer 314 and the further layer 317 may be deposited or otherwise attached by any suitable process providing the arrangement described above. Examples of such processes are sputter processes, physical vapor deposition (PVD) processes, chemical vapor deposition (CVD) processes or the like. In the embodiment shown, the first layer 314 is bonded to the base body 316 by a suitable bonding or other attaching process. Examples for such attaching processes are wringing or optical contacting, soldering, adhesive bonding, fusion bonding, low temperature bonding etc.

Furthermore, it wiii be appreciated that the geometry described above, in particular the combined geometry of the first and second layer section, may be obtained by removing material from the first layer previously attached or by attaching a first layer of locally varying thickness, the varying thickness being obtained prior to the attachment (e.g. using a material removal process, a molding process or a masking process) or upon attachment (e.g. using a molding or a masking process). In particular, the local thickness of the first layer may arbitrarily vary, i.e. a first layer having an arbitrarily stepped and/or curved cross-section may be obtained. This may for example be used for optimizing the shape of the pimples 310.

It will be appreciated that, if the required planarity tolerances of the contact surfaces 310.1 of the pimples 310 with the wafer 107 are not provided by the layer attachment processes used, the contact surfaces 310.1 may be commonly worked using a suitable process in order to meet these planarity tolerances. Examples of such working processes are polishing, lapping or the like.

If this is the case, preferably, the space 313 between the pimples 310 is filled with a preferably easily removable filling material, such as a lacquer or the iike, up to the top of the pimples to avoid deposition of less easily removable substances on the surface of the wafer table 308. The continuous surface obtained With this filling material also provides the possibility to easily perform an interferometric determination of the surface shape.

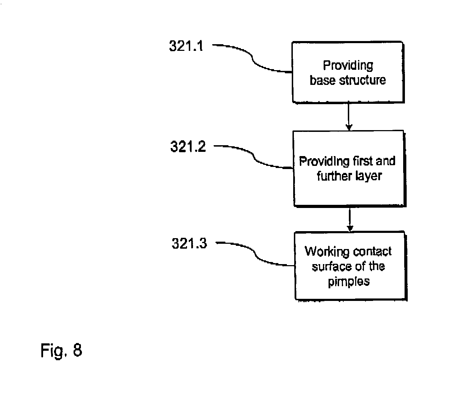

Figure 8 shows a block diagram of a preferred embodiment of a method of manufacturing the wafer table 308 according to the invention that is used during operation of the optical exposure apparatus 101.

In a first step 321.1, the base body 316 is provided having the shape as described above. To this end, in a first partial step, two pieces of bulk cordierite sinter material are pre-sintered to a certain density degree, e.g. 80% of the final density of the base body 316, to provide an upper half pre-form and a lower half pre-form of the base body 306. In a second partial step, all the features of the base body 316, e.g. the venting channels 311, the cooling channels 318 and the platform elements 308.2 are machined to the respective upper half pre-form and a lower half pre-form of the base body 306. In a third partial step, the upper half pre-form and a lower half pre-form of the base body 306 are connected and then fully sintered together with a thin layer of bonding material in between them. The bonding material is preferably substantially similar to the material of the pre-forms. Such a process allow very good final tolerances to be achieved at the finished base body while retaining full material properties at the bonding interface.

As a first alternative, in a first partial step of the first step 321.1, at least a first component and a second component of the base body 316 are given their final shape and fully sintered. In a second partial step, the fully sintered first component and the fully sintered second component of the base body 316 are bonded together to form the base body 316 with all its features. The bonding process can be any of the usual ceramic bonding processes, including fusion bonding, glass bonding, brazing, or so-called low temperature bonding.

As a second alternative, in the first step 321.1, the base body 316 is manufactured monolithically in one piece using a stereolithography process in combination with laser assisted sintering.

In a second step 321.2, a substantially plane parallel plate or wafer of silicon carbide (SiC) is bonded as the first layer 314 to the upper surface of the base body 316 in an inorganic room temperature bonding process. Then, if necessary, the upper surface of the first layer 314 is worked to the thickness and planarity specified for the later contact surface 310.1 of the pimples 310.

Then, in a machining process such as a sandblasting process, the raw outer shape of the platform elements 308.2 is formed from the first layer 314. It will be appreciated that, in certain embodiments of the invention, where the total thickness of the platform elements and the pimples exceeds the thickness of the first layer, in the sandblasting process, not only the first layer but also the base body is machined forming the raw outer shape of the platform elements 308.2 from the first layer and the base body and providing the design with the segments 325 of the first layer as it has been described above.

Then, in a further machining process such as a laser machining process, the first layer sections 314.1 defining the pimples 310 and the platforms 308.3 of the platform elements 308.2 are formed to provide the configuration described above. Of course, here as well, other machining techniques may be used to provide the shape described above.

Finally, the further layer 317 is deposited on the entire surface of the support area 308.1 in a PVD process. Especially in the embodiments with the mutually isolated segments 325 of the first layer sitting on the respective parts of the platform elements formed by the base body, the further layer 317 may serve to provide the electrically conductive connection between these segments 325.

In a third step 321.3, if necessary, the contact surfaces 310.1 of the pimples 310 are commonly worked to meet the planarity requirements for providing proper support to the respective wafer 107. Suitable working processes are for example commonly polishing or lapping the contact surfaces 310.1.

To measure the resulting global thickness of the wafer table 308, an ultra-flat reference wafer may be placed on top of the pimples 310 with a slight vacuum applied via the venting channels 311. The top surface of the reference wafer may then be used for indirect measurement using a large area plane interferometer. The unevenness of the reference wafer-itself can be calibrated out if the measurement is repeated multiple times with the wafer and the wafer table 308 being rotated relative to each other, e.g. at four times 90°.

In the foregoing, the invention has been described only in the context of microlithography applications. However, it will be appreciated that the invention may be used in the context of any other imaging process or process where a substrate to be treated is temporarily supported.

## Claims

1. A support structure for temporarily supporting a substrate in a support direction during treatment of said substrate comprising:
- a base structure and
- at least one layer connected to said base structure;
- said at least one layer defining at least one protrusion of said support structure;
- said at least one protrusion being adapted to contact said substrate when said substrate is supported by said support structure.

2. The support structure according to claim 1, wherein said at least one layer comprises a material that is at least one of a wear resistant material and an electrically conductive material,

3. The support structure according to claim 1, wherein
- said at least one layer comprises a material from a material group consisting of carbides, nitrides, borides, oxides, silicides,
- said at least one layer comprising, in particular, a material from a material group consisting of silicon carbide (SiC), tungsten carbide (WC), titanium nitride (TiN), diamond-like carbon (DLC), diamond, mono-crystalline silicon and mono-crystalline germanium.

4. The support structure according to claim 1, wherein
- said base structure comprises a base body made of a material having a coefficient of thermal expansion below 0.5·10⁻⁶ K⁻¹, said base body, in particular; being made of a material from a material group consisting of quartz, Zerodur®, Cordierite, ULE® glass, CLEARCERAM®.

5. The support structure according to claim 4, wherein said at least one layer is formed on said base body.

6. The support structure according to claim 4, wherein
- said base structure comprises at least one carrier element;
- said carrier element being connected to said base body;
- said at least one layer being formed on said carrier element,
- said at least one carrier element, in particular, comprising a material that is at least one of a wear resistant material and an electrically conductive material.

7. The support structure according to claim 1, wherein
- said base structure comprises at least one platform element protruding in said support direction and forming a platform facing in said support direction;
- said at least one layer being formed on said platform.

8. The support structure according to claim 1, wherein
- said at least one layer has a thickness in said support direction;
- said thickness varying in a direction transverse to said support direction.
- said at least one layer, in particular, having at least one location of maximum thickness,
- said location of maximum thickness defining a contact area where said protrusion contacts said substrate when said substrate is supported by said support structure.

9. The support structure according to claim 1, wherein
- said at least one layer comprises a first layer section and a second layer section,
- said second layer section being formed between said base structure and said first layer section.

10. The support structure according to claim 9, wherein said second layer section is formed monolithically with said first layer section.

11. The support structure according to claim 9, wherein said second layer section forms at least one of a stress distribution layer, a wear resistant layer, an electrically conductive layer and a layer improving the connection between said first layer and said base structure.

12. The support structure according to claim 9, wherein
- said second layer section comprises a material from a material group consisting of carbides, nitrides, borides, oxides, silicides;
- said second layer section, in particular, comprising a material from a material group consisting of silicon carbide (SiC), tungsten carbide (WC), titanium nitride (TiN), diamond-like carbon (DLC), diamond, mono-crystalline silicon and mono-crystalline germanium or comprising a material from a material group consisting of chromium (Cr) and tungsten titanium (WTi).

13. The support structure according to claim 9, wherein
- said first layer section has a first extension in a direction transverse to said support direction and
- said second layer section has a second extension in said direction transverse to said support direction;
- said second extension being at least twice said first extension,
- said second layer section, in particular, forming a substantially continuous coating of at least one surface area of said base structure.

14. The support structure according to claim 13, wherein
- a support area is provided, said support area being adapted to support said substrate;
- said support area comprising a plurality of protrusions including said at least one protrusion;
- said at least one surface area of said base structure extending over said support area.

15. The support structure according to claim 13, wherein
- said base structure comprises at least one platform element protruding in said support direction and forming a platform facing in said support direction;
- said at least one surface area of said base structure extending over said platform.

16. The support structure according to claim 9, wherein
- at least one of said first layer section and said second layer section has a maximum thickness between a few microns and a few tenths of millimeters
and/or
- said second layer section has a maximum thickness that is at least ten times a maximum thickness of said first layer section.

17. The support structure according to claim 1, wherein an electrically conductive coating is provided at a surface contacting said substrate when said substrate is supported by said support structure.

18. The support structure according to claim 1, wherein
- it forms at least part of a substrate table used in an optical exposure process, in particular a microlithography process, performed on said substrate,
- said substrate, in particular, being a wafer.

19. An optical exposure apparatus for transferring an image of a pattern formed on a mask onto a substrate comprising:
- an illumination system adapted to provide light of a light path;
- a mask unit located within said light path and adapted to receive said mask;
- a substrate unit located at an end of said light path and adapted to receive said substrate;
- an optical projection system located within said light path between said mask location and said substrate location and adapted to transfer an image of said pattern onto said substrate;
- said substrate unit comprising a support structure according to any one of the preceding claims, said support structure being adapted to support said substrate.

20. A method of manufacturing a support structure for temporarily supporting a substrate in a support direction during treatment of said substrate comprising:
- in a first step, providing a base structure and,
- in a second step, providing at least one layer connected to said base structure;
- said at least one layer having at least one layer section defining at least one protrusion of said support structure;
- said at least one protrusion being adapted to contact said substrate when said substrate is supported by said support structure,

21. The method according to claim 20, wherein
- said providing said at least one layer comprises attaching a layer material to a surface of said base structure;
- said layer material being at least one of a wear resistant material and an electrically conductive material.

22. The method according to claim 20, wherein
- said providing said at least one layer comprises attaching a layer material to a surface of said base structure;
- said layer material being a material from a material group consisting of carbides, nitrides, borides, oxides, silicides;.
- said layer material, in particular, being a material from a material group consisting of silicon carbide (SiC), tungsten carbide (WC), titanium nitride (TiN), diamond-like carbon (DLC), diamond, mono-crystalline silicon and mono-crystalline germanium.

23. The method according to claim 20, wherein
- said providing said at least one layer comprises attaching a layer material on a surface of said base structure;
- said attaching said layer material comprising at least one of a sputter process, a physical vapor deposition (PVD) process, a chemical vapor deposition (CVD) process and a bonding process.

24. The method according to claim 23, wherein
- said attaching said layer material on said surface comprises a sputter process using a mask unit;
- said mask unit providing at least one aperture located at a distance from said surface of said base structure;
- said aperture allowing accelerated layer material to pass said mask unit and to reach said surface.

25. The method according to claim 20, wherein
- said providing said base structure comprises providing a base body made of a base body material having a coefficient of thermal expansion below 0.5·10⁻⁶ K⁻¹;
- said base body material, in particular, being a material from a material group consisting of quartz, Zerodur®, Cordierite, ULE® glass, CLEARCERAM®.

26. The method according to claim 20, wherein
- said providing said base structure comprises providing a base body made of a sinter material;
- said base body being provided by one of a first process, a second process and a third process;
- said first process comprising, in a first partial step, fully sintering at least a first component and a second component of said base body and, in a second partial step, bonding together at least said first component and said sintered second component to form said base body;
- said second process comprising, in a first partial step, pre-sintering at least a first component and a second component of said base body, in a second partial step, connecting at least said pre-sintered first component and said pre-sintered second component to form a pre-form of said base body, fully sintering pre-form said to form said base body;
- said third process comprising forming said base body in a stereolithography process.

27. The method according to claim 20, wherein said providing said at least one layer comprises attaching said layer material directly to said base body.

28. The method according to claim 20, wherein
- said providing said base structure comprises providing at least one carrier element and connecting said at least one carrier element to said base body;
- said providing said at least one layer comprising attaching said layer material to said at least one carrier element;
- said at least one carrier element, in particular, being formed using a material that is at least one of a wear resistant material and an electrically conductive material.

29. The method according to claim 20, wherein
- said providing said base structure comprises providing at least a part of at least one platform element at said base structure, said at least one platform element protruding in said support direction and forming a platform facing in said support direction;
- said providing said at least one layer comprising forming said at least one layer section on said platform;
- said providing said at least one platform element, in particular, comprising working a part of said base structure using at least one of a machining process, an etching process and an erosion process.

30. The method according to claim 20, wherein
- said at least one layer has a thickness in said support direction;
- said thickness varying in a direction transverse to said support direction,
- said varying thickness being obtained by removing material from said at least one layer.

31. The method according to claim 20, wherein
- said at least one layer has a thickness in said support direction;
- said thickness varying in a direction transverse to said support direction,
- said at least one layer has at least one location of maximum thickness,
- said location of maximum thickness defining a contact area where said protrusion contacts said substrate when said substrate is supported by said support structure.

32. The method according to claim 20, wherein
- said at least one layer comprises a first layer material and has a first layer section and a second layer section,
- in said second step, said second layer section is formed between said base structure and said first layer section;
- said second layer section, in particular, forming at least one of a stress distribution layer, a wear resistant layer, an electrically conductive layer and a layer improving the connection between said first layer and said base structure.

33. The method according to claim 32, wherein said second layer section is formed monolithically with said first layer section.

34. The method according to claim 32, wherein
- said providing said second layer section comprises attaching a second layer material to a surface of said base structure;
- said attaching said second layer material comprising at least one of a sputter process, a physical vapor deposition (PVD) process, a chemical vapor deposition (CVD) process.

35. The method according to claim 32, wherein
- said at second layer section comprises a material from a material group consisting of carbides, nitrides, borides, oxides, silicides;
- said second layer section, in particular, comprising a material from a material group consisting of silicon carbide (SiC), tungsten carbide (WC), titanium nitride (TiN), diamond-like carbon (DLC), diamond, mono-crystalline silicon and mono-crystalline germanium.

36. The method according to claim 32, wherein
- said first layer section has a first extension in a direction transverse to said support direction and
- said second layer section has a second extension in said direction transverse to said support direction;
- said second extension being at least twice said first extension;
- said second layer section, in particular, forming a substantially continuous coating of at least one surface area of said base structure.

37. The method according to claim 36, wherein
- a support area is provided, said support area being adapted to support said substrate;
- said support area comprising a plurality of protrusions including said at least one protrusion;
- said at least one surface area of said base structure extending over said support area.

38. The method according to claim 36, wherein
- said providing said base structure comprises providing at least a part of at least one platform element at said base structure, said at least one platform element protruding in said support direction and forming a platform facing in said support direction;
- said at least one surface area of said base structure extending over said platform.

39. The method according to claim 32, wherein
- at least one of said first layer and said second layer has a maximum thickness between a few microns and a few tenths of millimeters
and/or
- said second layer section has a maximum thickness that is at least ten times a maximum thickness of said first layer section.

40. The method according to claim 20, wherein,
- in said second step, an area of said at least one layer is worked, said area being worked defining a contact area where said protrusion contacts said substrate when said substrate is supported by said support structure,
- said working said area defining said contact area, in particular, comprising at least one of a lapping process and a polishing process.

41. The method according to claim 40, wherein,
- said at least one layer defines a plurality of protrusions of said support structure comprising said at least one protrusion of said support structure;
- in said second step, an area of each one of said protrusions is worked, said area being worked defining a respective contact area where said protrusion contacts said substrate when said substrate is supported by said support structure;
- an intermediate space between said protrusions, in particular, being filled with a removable filling material prior to working said area defining said contact area.

42. The method according to claim 41, wherein, said protrusions are worked such that said contact areas defined by said protrusions together define a substantially planar contact geometry for said substrate.

43. The method according to claim 20, wherein, after forming said at least one layer, an electrically conductive coating is provided at a surface contacting said substrate when said substrate is supported by said support structure.
